# EUROPEAN PATENT SPECIFICATION

(11) **EP 2 136 421 B1**
(45) Date of publication and mention of the grant of the patent: **25.09.2013**
(21) Application number: 08010990.3
(22) Date of filing: 17.06.2008
(51) Int. Cl.: H01L 51/05, H01L 51/30, B82Y 10/00

(54) **New synthesis of hybrid polymer-metal nanostructures and hybrid polymer-metal compounds nanostructures for nanodevice applications**
Neue Synthese hybrider Polymermetallnanostrukturen und Nanostrukturen hybrider Polymermetallverbindungen für Nanobauelemente
Nouvelle synthèse de nanostructures hybrides de polymère-métal et nanostructures de composés hybrides de polymère-métal pour applications de nanodispositifs

(43) Date of publication of application: 23.12.2009
(73) Proprietor: IMAST S.c.a.r.l., 80121 Napoli (IT)
(72) Inventor: Borriello, Anna, 80055 Portici, Napoli (IT); Agoretti, Pasquale, 80026 Casoria, Napoli (IT); Cassinese, Antonio, 80132 Napoli (IT); Mohanraj, G.T., 80055 Portici (IT); Sanguigno, Luigi, 80059 Torre del Greco (IT)
(74) Representative: Torti, Carlo Maria Emilio

(56) References cited:
- I. YU. SAPURINA, J. STEJSKAL, M. TRCHOVA, D. HLAVATA, YU. F. BIRYULIN: "Organic Nanocolloidal Polyaniline Dispersions Containing Fullerene" FULLERENES, NANOTUBES AND CARBON NANOSTRUCTURES, vol. 14, 1 January 2006 (2006-01-01), pages 447-455, XP008098694
- SAPURINA I ET AL: "Polyaniline complex with fullerene C60" EUROPEAN POLYMER JOURNAL, PERGAMON PRESS LTD. OXFORD, GB, vol. 36, no. 11, 1 November 2000 (2000-11-01), pages 2321-2326, XP004215958 ISSN: 0014-3057
- YU. SAPURINA, A. V. GRIBANOV, M. V. MOKEEV, V. N. ZGONNIK, M. TRCHOVA, J. STEJSKAL: "Polyaniline Composites with Fullerene C60" PHYSICS OF THE SOLID STATE, vol. 44, no. 3, 2002, pages 548-549, XP002503810
- SUNIL K. PILLALAMARRI, FRANK D. BLUM, MASSIMO F. BERTINO: "Symthesis of polyaniline-gold nanocomposites using "grafting from" approach" CHEM. COMM., 25 August 2005 (2005-08-25), pages 4584-4585, XP002503807
- PING XU, XIJIANG HAN, JINGJING JIANG, XIAOHONG WANG, XUANDONG LI, AIHUA WEN: "Synthesis and Characterization of Novel Coralloid Polyaniline/BaFe12O19 Nanocomposites" J. PHYS. CHEM. C, vol. 111, 8 March 2007 (2007-03-08), pages 12603-12608, XP002503808
- YANG DONG, YING MA, TIANYOU ZHAI, YI ZENG, HONGBING FU, JIANNIAN YAO: "A novel approach to the construction of core-shell gold-polyaniline nanoparticles" NANOTECHNOLOGY, vol. 18, no. 45, 10 October 2007 (2007-10-10), page 455603, XP020129462 ISSN: 0957-4484
- M. K. BERA, M. K. SANYAL, S. PAL, J. DAILLANT, A. DATTA, G. U. KULKARNI, D. LUZET, O. KONOVALOV: "Reversible buckling in monolayer of gold nanoparticles on water surface" EPL, EUROPHYSICS LETTERS, vol. 78, no. 5, 1 June 2007 (2007-06-01), pages 56003-P1-56003-P6, XP020115383 ISSN: 0295-5075
- RICKY J. TSENG, JIAXING HUANG, JIANGYONG OUYANG, RICHARD B. KANER, YANG YANG: "Polyaniline Nanofiber/Gold Nanoparticle Nonvolatile Memory" NANO LETTERS, vol. 5, no. 6, 5 December 2005 (2005-12-05), pages 1077-1080, XP002503813
- MALLICK ET AL: "Hydrophilic behaviour of gold-poly (o-phenylenediamine) hybrid nanocomposite" MATERIALS SCIENCE AND ENGINEERING B, ELSEVIER SEQUOIA, LAUSANNE, CH, vol. 140, no. 3, 15 June 2007 (2007-06-15), pages 166-171, XP022130801 ISSN: 0921-5107
- OLIVEIRA M M; CASTRO E G; CANESTRARO C D; ZANCHET D; UGARTE D; ROMAN L S; ZARBIN A J G: "A simple two-phase route to silver nanoparticles/polyaniline structures", JOURNAL OF PHYSICAL CHEMISTRY B, vol. 110, 8 May 2006 (2006-05-08), pages 17063-17069, ISSN: 1520-6106, DOI: 10.1021/jp060861f
- JIAXING HUANG: "Synthesis and applications of conducting polymer polyaniline nanofibers", PURE APPL. CHEM., vol. 78, 31 December 2006 (2006-12-31), pages 15-27, DOI: 10.1351/pac200678010015

## Description

### FIELD OF THE INVENTION

The present invention relates to the field of hybrid nanostructures. In particular, the present invention relates to a process to produce hybrid polymer-metal and polymer-metal compounds.

### BACKGROUND OF THE INVENTION

Hybrid polymer-metal nanostructures, hybrid polymer-metal compounds and hybrid polymer-fullerenes nanostructures are a novel class of materials displaying distinctive physical and chemical properties. The properties of these materials are noticeably different from those of their single components, and, for this reason, hybrid nanostructures are currently under thorough investigation. These materials represents promising solutions in a wide range of fields of application, such as electronics, catalysis and biotechnology.

One of the main properties observed in some hybrid polymer-metal nanostructures is the electrical bistability. This phenomenon describes the presence of two states with different conductivities at the same applied voltage. One of the states displays low conductivity (OFF state), while the other is characterized by high conductivity (ON state). The ratio between the currents obtained at the same applied voltage in the two different states is called ON/OFF ratio of the system. The voltage at which the transition between the two states occurs is referred to as the switching voltage of the system. Once the system is in one of the two states, it remains steadily in this state until a voltage equal or higher than the switching voltage is applied. It is, thus necessary to apply a voltage higher than the switching voltage to a system in the OFF state to force it into the ON state. On the contrary, once the system is in the ON state, it is necessary to apply a negative voltage as high as the switching voltage to restore the OFF state. For this reason, hybrid polymer-metal nanostructures are ideal candidates for the formation of non-volatile memory devices, i.e. devices capable of retaining stored information even without the supply of power.

Hybrid polymer-fullerenes nanostructures are a novel class of materials whose properties are still under investigation. This hybrid nanostructures are formed by a polymeric structure decorated by fullerenes. Fullerenes are a family of carbon allotropes (molecules composed entirely of carbon) in the form of a hollow sphere, ellipsoid, tube or plane. Particularly relevant for the formation of hybrid polymer-fullerenes nanostructures are, for instance, buckyballs (spherical fullerenes), carbon nanotubes (cylindrical fullerenes), nano-onions (spherical particles based on multiple carbon layers surrounding a buckyball core), linked ball-and-chain dimers and fullerene rings.

Hybrid polymer-metal compounds nanostructures are formed by a polymeric structure decorated by nanoparticles formed by metal compounds. These nanoparticles formed by metal compounds may also have a non metallic nature.

One of the critical aspects of hybrid nanostructures is their synthesis process. The properties of these materials depend strongly, in fact, on the synthesis process employed to produce them. It is of major importance to control precisely the geometry of the hybrid polymer-metal nanostructures, hybrid polymer-metal compounds nanostructures and polymer-fullerenes nanostructures. The structure and the dimensions of the polymeric phase play an important role in the properties of the final hybrid nanostructures such as the stability of the material. On the other hand, it is extremely important to control the size and the distribution of the metal particles and of the fullerenes. It is known, in fact, that the electrical bistability is strongly dependent on the size of the nanoparticles and that, if the nanoparticles exceeds a certain size, the metallic nature of the particles dominates the properties of the system. In this case, the system does not exhibit electrical bistability, but it can be switched from the OFF state to the ON state only once, and then it remains in this state displaying an ohmic behavior [1].

According to the methods known in the prior art, hybrid polymer-metal nanostructures are produced by redox reactions between the polymers and precursor materials for the metallic particles, typically ionic metal compounds (salts). In [1] the first step of the preparation process is the synthesis of the polymeric structure. Subsequently, the polymeric structure is let react with a metal salt (for instance tetrabromoaurate or chloroaurate), In [2], the metal salt (chloroaurate) is employed as the oxidant for the polymerization reaction of the monomer.

A further example of direct reaction between polyaniline nanafibers and oxidizing metal ions such as Au³⁺ and Ag⁺ can be found in Pure Appl. Chem, Vol 78, No 1. pp. 15-27. 2008, by J. Huang. In Nano Letters, Vol. 5, No. 6, pp. 1077-1080 (200%, a digital memory device is disclosed based on the nanofibers obtained with the method described In the previous paper.

In all these cases it is extremely difficult to control the size and the distribution of the metal particles. Moreover, it is not possible to control and engineer the interaction between the metal particles and the polymeric structure.

Finally, M.M. Oliveira and colleagues (J. Phys. Chem. B, Vol. 110, pp. 17063-17069 (2006)) report on the development of a process for synthesizing hybrid silver nanopartiCles/polyaniline nanosheets.

### OBJECT OF THE INVENTION

In view of the mentioned problems incurred in the synthesis process of hybrid polymer-metal nanostructures, hybrid polymer-metal compounds nanostrucures or hybrid polymer-fullerenes nanostructures, it is an object of the present invention to provide a method of producing hybrid polymer-metal nanostructures and hybrid polymer-metal compounds nanostructures allowing to overcome these problems. In particular, it is an object of the present invention to provide a versatile method of producing hybrid polymer-metal nanostructures, hybrid polymer-metal compounds nanostructures wherein a large variety of polymers, metals and metals compounds can be chosen to form the hybrid nanostructures. Moreover, it as an object of the present invention to provide a method which allows to engineer the chemical and physical properties of the hybrid polymer-metal nanostructures and hybrid polymer-metal compounds nanostructures in a controlled way. More in particular, it is an object of the present invention to provide a method that allows to control the size distributions parameters of the metal particles in the hybrid nanostructures with high accuracy. It is a further object of the present invention to provide a method that allows to control the nature and the properties of the interaction between the metal nanoparticles and the polymeric structure. It is a further object of the present invention to provide a method that allows to engineer the structure of the polymer material in the hybrid polymer-metal nanostructures and hybrid polymer-metal compounds nanostructures. Moreover, it is an object of the present invention to provide a method of producing hybrid polymer-metal nanostructures and hybrid polymer-metal compounds nanostructures that can be performed in conjunction with a large variety of polymerization processes necessary to form the polymeric structure in the hybrid material.

It is a further object of the present invention to provide electronic devices comprising hybrid polymer-metal nanostructures, hybrid polymer metal compounds nanostructures. Moreover, it is an object of the present invention to provide several kinds of nanodevices suitable for several kinds of applications such as non volatile memory devices, field effect transistors, sensors. light emission diodes, photovoltetic cells, drug delivery systems, data storage and spintronics.

### SUMMARY OF THE INVENTION

According to the present invention, there is provide a method of producing hybrid polymer-metal nanostructures or hybrid polymer-metal compounds nanostructures which is based on the inventive concept of providing first a dispersion of metal nanoparticles, or of metal compounds nanoparticles and subsequently polymerizing the polymer structure in the presence of said dispersion of metal nanopartides, or of metal compounds nanoparticles as defined in claim 1.

Preferred embodiments are given In the subclaims as well as the following specification,

### BRlEF DESGRIPTfON OF THE DRAWINGS

Fig. 1 shows the thermogravimetric analysis (TGA) of hybrid polyaniline-gold nanostructures synthesized according to a preferred embodiment of the present invention.
Fig. 2 shows the particles size distribution curve for gold nanoparticles in a hybrid polyaniline-gold nanostructure synthesized according to a preferred embodiment of the present invention.
Fig. 3 displays a nanoelectronic device in planar configuration including a film comprising hybrid polymer-metal nanostructures synthesized according to a preferred embodiment of the present invention.
Fig. 4 shows the I-V curve obtained by scanning the voltage applied between two adjacent electrodes of the nanoelectronic device of Fig. 3.
Fig. 5 shows the I-V curves obtained by scanning repeatedly the voltage applied between two adjacent electrodes of the nanoelectronic device of Fig. 3.
Fig. 6 shows the I-V curve obtained by scanning the voltage applied between two adjacent electrodes of the nanoelectronic device of Fig. 3 both for positive and negative values of the polarity.
Fig. 7 shows the I-V curves obtained by scanning the voltage applied between two adjacent electrodes of the nanoelectronic device of Fig. 3 for four different values of the operating temperature.
Fig. 8 shows the resistivity of the nanoelectronic device of Fig. 3 measured during a voltage scan between -500 V and +500 V.

### DETAILED DESCRIPTION OF THE INVENTION

In a preferred embodiment of the present invention, a method of producing hybrid polymer-metal nanostructures and hybrid pollymer-metal compounds nanostructure is provided, the method comprising the steps of providing a dispersion of metal nanoparticles, of of metal compounds nanoparticles in an aqueous phase and polymerizing a conducting polymer in the presence of said dispersion.

In a further preferred embodiment of the present invention, a method of producing hybrid polymer-metal nanostructures is provided, wherein the step of providing a dispersion of metal nanoparticles further comprises the step of functionalizing the metal nanoparticles with an organic ligand. Functionalizing the metal nanoparticles with an organic ligand allows to control the interaction between the metal nanoparticles and the polymeric structure in the final hybrid polymer-metal nanostructure. The interaction between the metal nanoparticles and the polymer structure is fundamental for the stability of the hybrid nanostructure. It is possible to choose organic ligands that allow for the stability of the hybrid nanostructure for instance over wide range of temperatures and other operating conditions (pressure, humidity, etc). Moreover, the interaction between the metal nanoparticles and the polymer structure is one of the fundamental parameters determining the physical and chemical properties of the hybrid material. Providing the functionalized metal nanoparticles in the hybrid polymer-metal material with organic ligands displaying specific properties allows to tailor the hybrid polymer-metal material for several kinds of applications, such as non-volatile memory devices, field effect transistors, sensors, light emitting diodes and photovoltaic cells. Furthermore, the organic ligands can play the fundamental role of protection for the nanoparticles, and they can prevent on one hand the segregation of the nanoparticles or, on the other hand, the aggregation into larger clusters. There are several kinds of organic ligands suitable to functionalize the metal nanoparticles: the metal nanoparticles can be coated for instance with alkanethiols and alkanethiol derivatives. Examples are: thiols (dodecanethiol, naphtalenethiol, benzylthiol, phosphinethiol, amido-acetyl alkanethiol, thioglycerol, aminothiophenol); DNA; mercaptobenzoic acid; mercaptohexanol; sulfonated polystyrene or paramethylstyrene; polypeptides; hyperbranched polymers and polyelectolytes; dodecylamine; amino-phosphate; mercaptoalkyl alcoxysilane; mercaptoethanol; mercaptosilanes; mercaptocarboxylic acids (mercaptoacetic acid, mercaptopropionic acid, mercaptosuccinic acid, mercaptobenzoic acid, mercaptoundecanoic acid).

In yet another preferred embodiment of the present invention, the metal nanoparticles are made of at least one of gold, cobalt, nickel, ruthenium, osmium, molybdenum, tungsten, yttrium, lutetium, copper, manganese, chromium, zinc, palladium, silver, platinum, tin, tellurium, bismuth, germanium, antimony, aluminum, indium, selenium, cadmium, gadolinium, hafnium, magnesium, titanium, lanthanum, cerium, praseodymium, neodymium, terbium, dysprosium, holmium, erbium iridium, rhodium, iron, titanium, lead, zirconium, vanadium and alloys composed of these metals. Suitable precursors are metal compounds such as tetrabromoaurate, chloroaurate, palladium nitrate, cadmium sulfide, cobaltosic oxide, lead sulfide, zinc sulfide, titanium oxide, iron oxides, zirconium oxide, iron chloride, tungsten and molybdenum acids. The choice of the metal can be made in view of the desired properties of the hybrid polymer-material nanostructures. Besides metals suitable for the application of the hybrid polymer-metal nanostructures for electronic devices, it is possible to choose metals with specific catalytic activities in order to employ the hybrid materials in catalysis processes.

The nanoparticles may also be made of metal compounds such as: CdTe, CdSe, CdS, ZnS, GaN, Ag₂S. C_{U}S₂, CuTe, CuSe.

The particle size distribution parameters of the metal nanoparticles in the hybrid polymer-metal nanostructures are fundamental for determining the properties of the hybrid material. In the method of producing polymer-metal nanostructures of the present invention, these parameters are highly controllable, and allow to tailor the hybrid material to several kinds of applications.

In a particularly favorable embodiment of the present invention, the metal nanoparticles in the hybrid polymer-metal nanostructure have a mean particle size of 25 nm or less.

In a further embodiment of the present invention, the metal nanaparticles In the hybrid polymer-metal nanostructure have a size uniformity of 2 nm or less.

According to the present disclosure, the fullerenes in the hybrid polymer-fullerenes nanostructures are at least one of buckyballs, carbon nanotubes, nano-onions, linked ball-and-chain dimers and fullerene rings.

In the present invention, the conducting polymer forms nanofibers or nanoparticles. In a further preferred embodiment of the present invention the nanofibers have a mean diameter of 100 nm or less. In yet another preferred embodiment of the present invention, the nanofibers have a length ranging from at least 50 nm to 100 µm. In a further favorable embodiment of the present invention the nanofibers have a mean diameter of 100 nm or less and a length ranging from at least 50 nm to 100 µm.

In a further preferred embodiment of the present invention, the conducting polymer is polyaniline (PANI). Polyaniline is a conducting polymer with unique properties. It is easily synthesized and, for this reason, it is available at low costs. It is highly stable in several environmental conditions. Its electrical and optical properties are easily tunable with simple acid/base doping/cledoplng processes. For these reasons the employment of polyaniline in hybrid polymer-metal or hybrid polymer-fullerenes nanostructures is particularly advantageous, for instance, for their application in sensor or electronic devices. Moreover, it is possible to synthesize polyaniline in the form of nanofibers which can form the polymeric structure in the hybrid polymer-metal nanostructures, or in the hybrid polymer-metal compounds nanostructures or in the hybrid polymer-fullerenes nanostructures. According to the present invention, the structural properties of the polyaniline nanofibers (such as average length and average diameter) can be precisely controlled. The diameter of the PANI nanofibers is preferably 60 nm or less. The length of the PANI nanofibers is preferably at least 50 nm. Moreover, polyaniline can be synthesized in the form of nanoparticles which can form the polymeric structure in the hybrid nanostructures.

Other examples of conducting polymers are for instance polypyrrole, polyvinylpyrrolidine. polyurethane, polythiophene, polyfluorene.

The conducting polymers can be synthesized in several forms such as conducting polymer nanostructures like nano-rods, nanotubes, nano-wires, nanoparticles and nanofibers.

The method of producing hybrid polymer-metal nanostructures, hybrid polymer-metal compounds nanostructures or hybrid polymer-fullerenes nanostructures disclosed herewith can be performed in conjunction with a large variety of polymerization processes necessary to form the polymeric structure in the hybrid material.

In a parucularly advantageous embodiment disclosed herewith, the step of polymerizing a conducting polymer in the presence of the metal nanoparticles dispersion, or of metal compounds nanoparticles dispersion or of the fullerenes dispersion is performed by interfacial polymerization. In this process, the polymerization reaction takes place at the interface between an aqueous and an organic phase in a biphase system. The polymer formed at the interface diffuse in the aqueous phase allowing for the continuous availability of reaction sites at the interface. In this exemplary embodiment of the present invention, the aqueous phase comprises the dispersion of metal nanoparticles or of metal compounds nanoparticles or of fullerenes. In a particular embodiment of the present invention, the preparation of the aqueous phase for the interface polymerization process comprises the steps of synthesizing metal nanoparticles, functionalizing the metal nanoparticles with an organic ligand, preparing a mixture of water and surfactant, dispersing the functionalized metal nanoparticles In the mixture of water and surfactant, treating the system with ultrasonication, adding an initiator agent, adding a doping agent Examples of surfactants are Dodecylbenzenesulfonic acid, Sodium dodecylsutfate, Ammonium lauryl sulfate and other alkyl sulfate salts, Sodium laureth sulfate, Akyl benzene sulfonate, Cetyl trimethylammonium bromide, Cetylpyridinium chloride, Polyethoxylated tallow amine, Benzalkonium chloride. Benzethonium chloride, Dodecyl betaine, Dodecyl dimethylamlne oxide, Cocamldopropyl betaine. Cocoampho glycinate, Alkyl poly(ethylene oxide), Copolymers of poly(ethylene oxide) and poly(propylene oxide). Alkyl polyglucosides including: Octyl glucoside. Decyl maltoside, Cetyl alcohol, Oleyl alcohol, Cocamide MEA, Cocamide DEX and Cocamide TEA and silicone-based surfactants.

Examples of initiator agents are ammonium persuffate, potassium bichromate, hydrogen peroxide, ferric chloride, Na₂S₂O₈ and K₂S₂O₈. Ce(SO₄)₂ KMnO₄, KBrO₃, KlO₃, R₂O₂. V₂Os, NaVO₃, NaClO and metallic ions. Examples of doping agents are (1S)-(+)-camphorsulfonic acid, (1R)-(-)-camphorsuffonic acid, (+)-camphorsulfonic acid, (±)-camphorsulfonic acid, L-tartaric acid and D-tartaric acid, HCl, H_{2S}O₄, HNO₃, HClO₄. H₃PO₄, acetic acid, formic acid, methanesulfonic acid, ethylsulfonic acid, toluenesulfonic acid, methytbenzene sulfonic acid, naphtalene sulfonic acid, dinitronaphtol sulfonic acid and polystyrene sulfonic acid. The preparation of the organic solution comprises the step of mixing the monomers with a reagent such as CCl₄, benzene, toluene, methylene chloride, xylene, hexane, diethylether, dichloromethane, carbon disufide tetrahydrofuran, chloroform, methylene chloride, N-methyl-2-pyrrolidinone, or other polar aprotic solvent dimethyl acetamide, dimethyl formamide, ethyl acetate or other ester solvent and alcohols. The aqueous phase is slowly added to the organic phase to form the biphasic system. The organic phase may comprise aniline, methylaniline, ethylaniline, alkoxyaniline e dialkoxyaniline, but other carbon-based organic monomers can be used, such as pyrrole, thiophene, toluidine, anisidine.

In yet another preferred embodiment disclosed herewith, the step of polymerizing a conducting polymer in the presence of the metal nanoparticles dispersion or of the metal compounds nanoparticles dispersion or of the fullerenes dispersion is performed by one of rapidly mixed reactions such as disclosed in [3], dilute polymerization such as disclosed in [4], sonication such as disclosed in [5], electrochemical polymerization or chemical polymerization reactions in the presence of structural directing agents such as templates like membranes or porous materials. Each of these processes can be performed in the presence of a dispersion of metal nanoparticles or of metal compounds nanoparticles or of fullerenes allowing for the versable synthesis of hybrid polymer-metal nanostructures, hybrid polymer-metal compounds nanostructures or of hybrid polymer-fullerenes nanostructures according to a preferred embodiment of the present invention.

In yet a further embodiment disclosed herewith, a hybrid nanostructure is provided, said hybrid nanostructune being obtainable with the producing method according to the present invention.

In a further embodiment disclosed herewith, an electronic device comprising a layer including the hybrid nanostructure obtainable with the producing method according to the present invention is provided.

In yet a further embodiment disclosed herewith, an electronic device comprising a layer including the hybrid nanostructures obtainable with the producing method according to the present invention and formed by a composite material comprising hybrid polymer-metal or polymer-fullerenes nanostructures dispersed in a polymeric matrix is provided. Examples of polymers suitable for the formation of the polymeric matrix are polystyrene, polyvinyl alcohol, polyvinyl chloride, poly-methyl methacrylate, cross-linked poly-4-vinylphenol, polyethylene oxide, poly(N-ethyl-2-vinylcarbazole), polyolefines, polyamides polyesters, polyester ketone, polyimides, polyurethanes, polychlorotrifluoroethylene. The polymeric matrix is of fundamental importance for the employment of the hybrid polymer-metal nanostructures and polymer-fullerenes nanostructures in nanodevice applications. The polymeric matrix may function as supporting matrix for the hybrid nanostructures. The polymeric matrix may confer high homogeneity and stability to the system. Because of the homogeneity of the system formed by hybrid nanostructures dispersed in a supporting polymeric matrix, a higher control on the scaling and the modeling of the nanodevices is achieved. Moreover, even if the primary role of the supporting polymeric matrix is that of forming an insulating matrix that prevents shorting out of the nanodevice, it is also possible to control the performances of the device by properly controlling the chemical composition of the supporting matrix. The physical properties of the supporting matrix such as the dielectric constant, the density, the thermal and mechanical properties contribute in fact to the performances of the device. By properly choosing the supporting matrix in which the hybrid polymer-metal and polymer-fullerenes nanostructures are dispersed, it is, thus, possible to tailor the nanodevice to several kinds of applications, such as non volatile memory devices, field effect transistors (FET), sensors, light emission diodes (LED), photovoltaic cells, drug delivery systems, data storage, spintronic and the like.

In order to form the composite material comprising the hybrid polymer-metal nanostructures, the hybrid polymer-metal compounds nanostructures or the hybrid polymer-fullerenes nanostructures in the supporting polymeric matrix, various amounts of hybrid nanostructures synthesized according to the method of the present invention may be dispersed in a solution of the supporting polymer. The content of hybrid nanostructures in the composite material may preferably range from 1% to 10%. The dispersion of hybrid nanostructures in a solution of the supporting polymer may be performed by techniques known in the art such as sonication or stirring techniques. The composite material may be coated on the electrodes of the nanodevice by known coating techniques such as spin-coating, spray coating, drop coating, coating techniques employed in association with photolithography masking techniques and the like.

### EXPERIMENTAL

In the following, the present invention is described with reference to a preferred embodiment as illustrated in the following detailed description. Accordingly, this description is to be construed as illustrative only and is for the purpose of teaching those skilled in the art the general manner of carrying out the present invention.

The following section is organized as follows: the first subsection illustrates the details of the synthesis process of a preferred polymer-metal hybrid nanostructure according to a preferred embodiment of the present invention, the second subsection describes the fabrication of a nanoelectronic device comprising the polymer-metal hybrid nanostructure synthesized according to the preferred embodiment described in the first subsection, finally, the third subsection shows the properties of the nanoelectronic device fabricated according to the exemplary procedure described in the second subsection.

### Synthesis

In the following subsection the method of producing polyaniline nanofibers decorated with gold nanoparticles according to a preferred embodiment of the present invention is described.

In the first step of the preferred production method, dodecanethiolate-functionalized gold nanoparticles with 3-4 nm mean particle size are synthesized according to a standard procedure such as disclosed in [6]. In particular, 0.79 g of HAuCL₄·3H₂O in 50 mL of deionized water are added to a solution of 2.8 g of tetraoctylammonium bromide in 160 mL of toluene. After isolating the organic phase, the desired amount of dodecanethiol is added and the resulting solution is stirred for 10 minutes. The Au:dodecanethiol ratio determines the mean particle size of the gold nanoparticles as shown for instance in [6]. 0.77 g of NaBH₄ in 50 mL of deionized water are added over periods of 5 minutes. The solution is stirred at room temperature for 3.5 hours. The organic phase is collected and the solvent is removed by evaporation at 50°C. The product is suspended in 150 mL of ethanol, sonicated, collected on a glass filtration frit, washed with ethanol and acetone and finally dried in vacuum.

In the second step, a dispersion of the dodecanethiolate-functionalized gold nanoparticles in deionized water and dodecylbenzenesulfonic acid (DBSA) is provided.

For this purpose, 20 mg of the dodecanethiolate-functionalized gold nanoparticles synthesized as described above are added to a solution formed by 200 mL of deionized water and DBSA so that the Au:DBSA ratio is 1:2.5. The obtained dispersion is sonicated (20 kHz) for 48 hours. The dispersion displays the typical gray color.

In the third step of the exemplary production method, polyaniline nanofibers are polymerized in the presence of the dispersion of dodecanethiolate-functionalized gold nanoparticles provided in the second step. In this exemplary production method the polymerization is performed by an interfacial polymerization process. For this purpose, 1.127 g of ammonium persulfate (APS) (initiator agent) and 47.41 g of camphorsulfonic acid (CSA) (doping agent) are added to the dispersion of dodecanethiolate-functionalized gold nanoparticles. The dispersion of dodecanethiolate-functionalized gold nanoparticles including the initiator and the doping agents is slowly added to an organic solution made of 200 mL of CCl₄ and 2 mL of Aniline. The dispersion and the organic solution form an interface and the system has a biphasic nature. The so prepared biphasic reaction mixture is sealed off, and after a reaction time of 24 hours the polymerization process is completed. The polymerization process occurs at the interface between the organic solution and the aqueous dispersion of nanoparticles. The as-prepared polyaniline is in a hydrophilic form and for this reason it diffuses away from the interface into the aqueous region giving rise to the formation of nanofibers: the diffusion of polyaniline from the interface towards the aqueous region allows for the continuous availability of reaction sites at the interface and, at the same time, prevents the overgrowth of irregularly shaped agglomerates of the polymer. During this polymerization process, the dodecanethiolate-functionalized gold nanoparticles dispersed in the aqueous region are trapped by the growing polyaniline nanofibers. Because of this growth mechanism, some of the dodecanethiolate-functionalized gold nanoparticles are trapped inside the nanofibers, while others are bound on the external surface of the polymer nanostructures. When the polymerization process is completed, the aqueous region comprises the hybrid polymer-metal nanostructures and displays the typical green color. At this point the aqueous phase is separated from the organic phase and it is filtered in vacuum. The residue obtained from the filtration process is further washed with deionized water and acetone and finally dried in vacuum at a temperature of 80 °C. The final product of this process consists in the hybrid polyaniline-gold nanostructures formed by nanofibers of polyaniline decorated with gold nanoparticles.

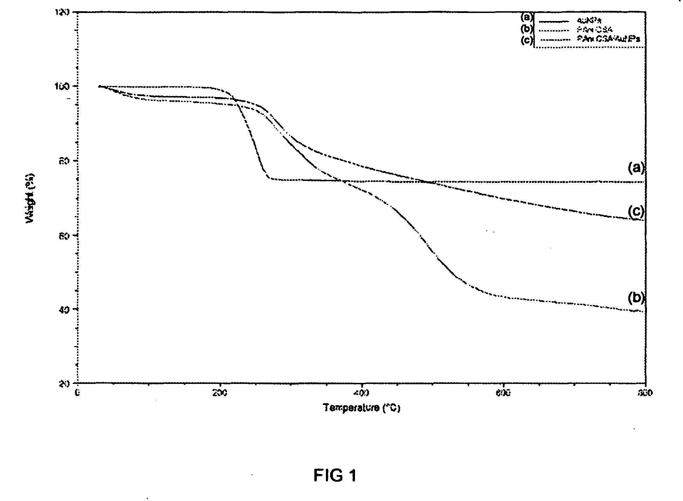

Fig. 1 shows the thermogravimetric analysis (TGA 2950 Thermogravimetric Analyzer, TA Instruments) of the hybrid polyaniline-gold nanostructures synthesized according to the above described production method. The thermal scan is performed in a nitrogen atmosphere between 30°C and 800°C with a heating rate of 10°C/min. Curves (a) and (b) correspond to samples of pure dodecanethiolate-functionalized gold nanoparticles and pure polyaniline fibers, respectively, while curve (c) relates to the hybrid polyaniline-gold nanostructures. Curve (a) shows a single degradation feature between 190°C and 275°C corresponding to the decomposition of the dodecanethiol. Curve (b) measured on the pure polyaniline nanofibers displays two degradation features: the first between 200°C and 350°C, the second between 400°C and 550°C. The first feature corresponds to the decomposition of the camphorsulfonic acid, while the second corresponds to the deterioration of the structure of the nanofibers. Curve (c) measured on the hybrid polyaniline-gold nanostructures displays a single degradation features between 200°C and 350°C corresponding to the decomposition of the camphorsulfonic acid, and a smooth degradation trend towards high temperature due to the slow diffusion of gas through the nanofibers comprising the gold nanoparticles. The final residue (65%) is higher than the residue in the case of pure polyaniline nanofibers (40%). These results show that the majority of gold nanoparticles are trapped and protected inside the polyaniline nanofibers structure and that the hybrid polyaniline-gold nanostructure are formed by about 25% of gold.

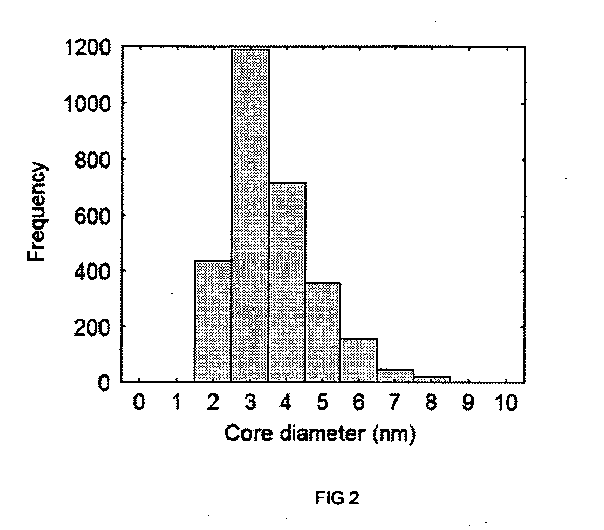

Fig. 2 shows the particles size distribution curve of the gold nanoparticles obtained by the analysis of Transmission Electron Microscopy (Jeol JEM 1220 Microscope) images of the hybrid nanostructures. The mean particle size is 3.6 nm with a uniformity of 3.6 ± 1 nm. The uniformity is calculated by considering the standard deviation of the data.

Moreover, TEM images of the hybrid nanostructures show that the diameter of the polyaniline nanofibers measures 40 to 50 nm, and their length ranges from about 100 nm to about 10 µm.

### Nanoelectronic devices

The following subsection describes the fabrication of a nanoelectronic device employed for the characterization of the hybrid polyaniline-gold nanostructures produced according to the exemplary embodiment of the present invention described in the previous subsection.

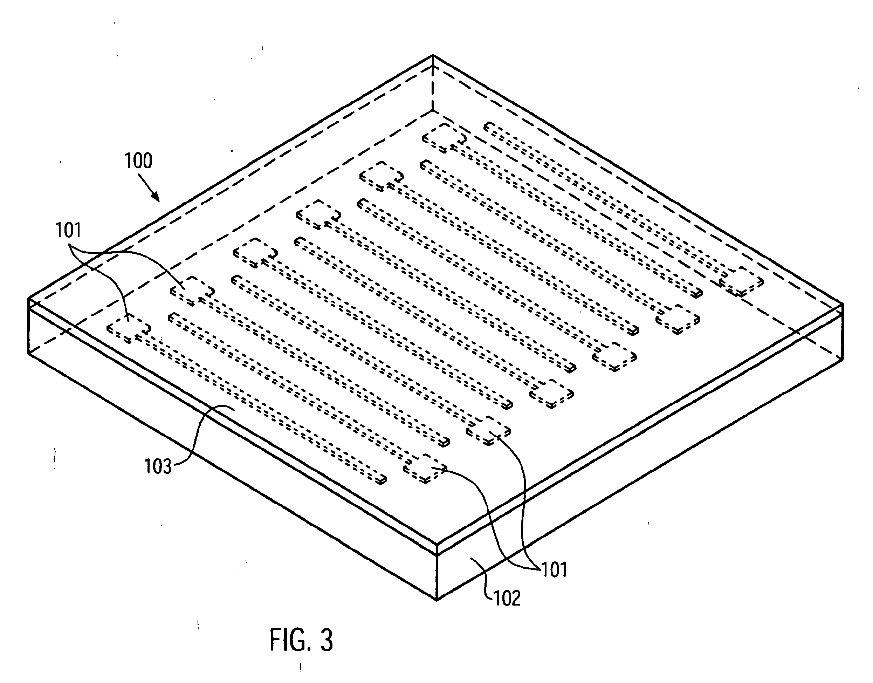

Fig. 3 schematically displays a nanoelectronic device (100) in planar configuration employed for the characterization of the materials synthesized. The conducting electrodes (101) are mutually parallel and lay on an insulating substrate (102). The system is covered by a film (103) comprising the hybrid polyaniline-gold nanostructures. The planar configuration of the electronic device shown in Fig. 3 is an exemplary configuration for such a device. Alternatively, the nanoelectronic device can be fabricated in the multilayer configuration with the film comprising the hybrid nanostructures placed between overlapping electrodes. The planar configuration adopted for the characterization described in this subsection is particularly advantageous because it guarantees that the measured conductivity properties relate only to the film comprising the hybrid polyaniline-gold nanostructures and not to diffusion phenomena that may occur in the multilayer configuration.

In the first step of the exemplary fabrication procedure, aluminum electrodes (101) are formed by a sputtering process on a precleaned glass substrate (102) (Agar Sputter Coater, Assing Scientific). The electrodes have a length of 5 mm, a width of 0.1 mm and a thickness of 70 nm. They are placed in a parallel planar configuration at a distance of 0.1 mm from each other.

The hybrid polyaniline-gold nanostructures produced according to the process described in the previous subsection are dispersed in CHCl₃ by sonication (59 kHz) for 48 hours (Elma, D-78224, Transsonic Digitals). Alternatively, the polyaniline-gold nanostructures are dispersed in CCl₄. Subsequently, atactic polystyrene (aPS) is added to the obtained dispersion at 80°C for 30 minutes in order to obtain a composite material formed by hybrid polyaniline-gold nanostructures dispersed in a supporting polystyrene matrix. The content of polyaniline-gold nanostructures in the composite material ranges preferably from 1% to 10%.

The so obtained composite material is deposited on the glass substrate (102) comprising the aluminum electrodes (101) by spin coating (Cee^{R} Model 100, Brewer Science), so as to obtain a uniform film (103) with a thickness of 100 nm to 500 nm.

The thickness and the roughness of the electrodes (101) and of the film (103) comprising the hybrid polyaniline-gold nanostructures are characterized by a profilometer (XP 1 Series Stylus Profiler, Ambios Technology).

### Characterization of the electronic properties of the nanoelectronic devices

The results described in this subsection refer to a nanoelectronic device (100) fabricated according to the exemplary method described in the previous subsection. The content of polyaniline-gold nanostructures in the composite material employed to form the film (103) on the conducting electrodes (101) is 6.4%. The electronic properties are measured by a picoammeter coupled with a voltage source (Keithley 487). The temperature of the device is regulated and measured by a cryogenic probe station (Lakeshore Cryotronics) coupled with a temperature controller (Model 218, Janis Research Company).

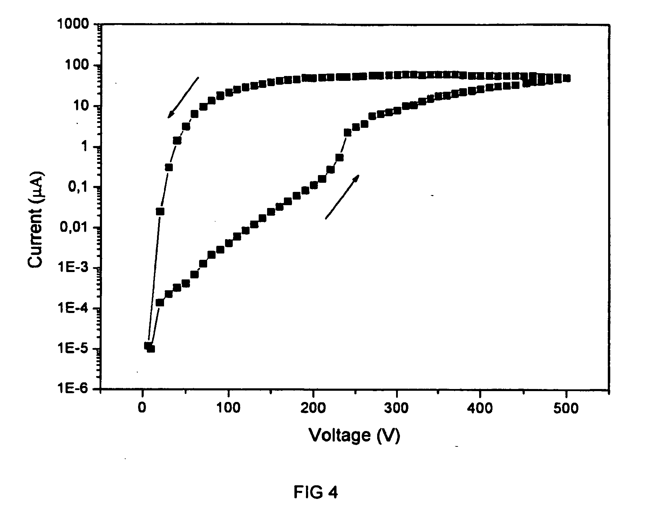

Figures 4 - 8 show the results obtained performing the measurements as described below between two adjacent electrodes (101) of the nanoelectronic device (100). In all the measurements, the voltage scans are performed in a stepwise manner: the voltage is increased or decreased according to a step-like function with a step-height of 10 V and a step-width of 5 sec.

Fig. 4 shows the I-V curve obtained by scanning the voltage applied between two adjacent electrodes of the nanoelectronic device from 0 V to +500 V and, subsequently, from +500 V to 0 V. The system exhibits a bistable electrical behavior shown by the hysteresis-like curve obtained by scanning the voltage. When the voltage is increased from 0 V, the system exhibits low conductivity (OFF state). At about +240 V, the current suddenly increases and the system displays high conductivity (ON state). Once the ON state is established at high voltage, it is stable even decreasing the voltage towards 0 V. The current measured in the high conductivity state is 5 to 6 orders of magnitude higher than the current in the low conductivity state. The ratio between the currents measured in the high and in the low conductivity states at the same voltage represents the ON/OFF ratio of the device.

The bistable behavior is observed at high voltages (+240 V) because of the parallel planar configuration of the electronic device employed to characterize the hybrid polyaniline-gold nanostructures synthesized according to the preferred embodiment of the present invention described in the previous subsections. In the parallel configuration the electrodes are at a mutual distance which is about two orders of magnitude higher than the mutual distance between the electrodes in a typical multilayer configuration with the bistable material placed between overlapping electrodes. For this reason, the bistable behavior would be observed at about +2 V in a device with multilayer configuration.

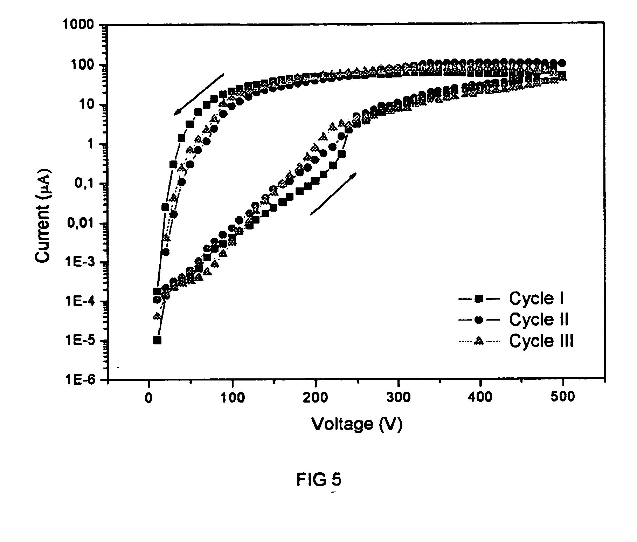

Fig. 5 shows the results of a test performed by submitting the device to repeated voltage scan cycles with the voltage ranging from 0 V to +500 V and then from +500 V to 0 V. The graph displays the results for three cycles. The bistable behavior is reproducible and the system follows the same hysteresis curve during the various voltage scan cycles. This test shows that the composite material comprising the hybrid polyaniline-gold nanostructures synthesized according to a preferred embodiment of the present invention is stable even when it undergoes several voltage cycles, and it exhibits a perfectly reproducible behavior. This property is important for several applications of the nanoelectronic device comprising the hybrid polyaniline-gold nanostructures. The ability of undergoing several ON/OFF switches under the same conditions is a fundamental property for the application of the nanoelectronic device for instance as non-volatile memory device.

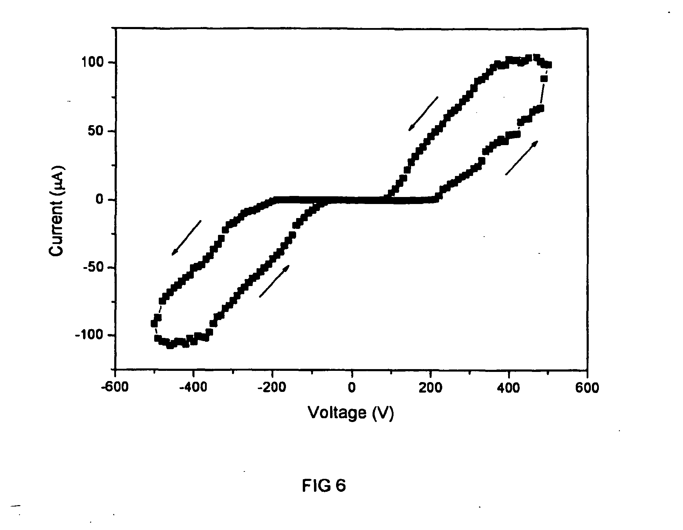

Fig. 6 shows the results of a voltage cycle wherein the voltage is firstly increased from 0 V to + 500 V, then it is decreased from +500 V to -500 V, and, finally, it is increased from -500 V to 0 V. The system displays a perfectly symmetric bistable behavior with the switching between the OFF and ON states at about +240 V in the positive region of the applied voltage, and at about -240 V in the negative region. The intensity of the current measured in the conducting states is independent from the polarity of the applied voltage.

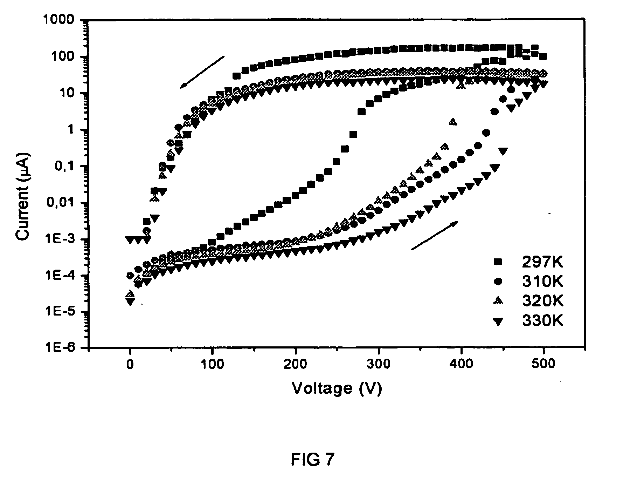

Fig. 7 displays the results obtained by performing voltage scan cycles at different temperatures. The system displays the hysteresis-like I-V curves in a wide range of operating temperatures, showing that the bistable behavior is maintained even varying the temperature. The switching voltage increases by increasing the temperature because of the thermal expansion of the supporting polystyrene matrix. The area of the hysteresis cycles, on the contrary, is constant. Consequently the ON/OFF ratio of the device is independent on the operation temperature.

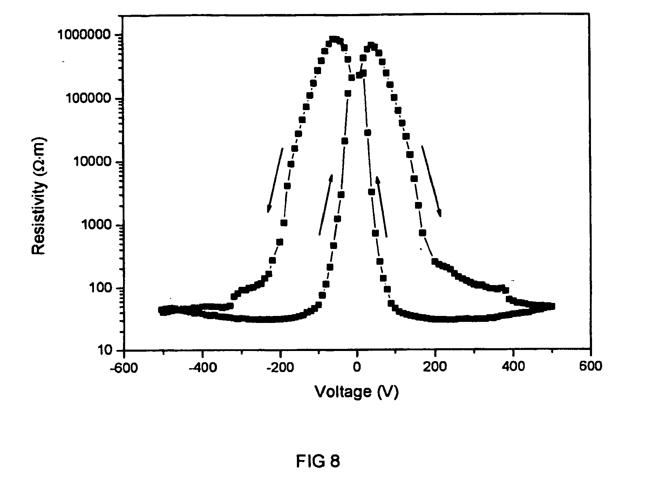

Fig. 8 shows the resistivity of the system submitted to a voltage scan from -500 V to +500 V followed by a scan from +500 V to -500 V. The resistivity of the system varies by several orders of magnitude between the ON and the OFF states. The low value of the resistivity in the ON states is particularly advantageous because it is correlated with a low value of the switching voltage and it allows to minimize dissipation processes.

The tests shown in the Figures 4 to 8 demonstrate that the hybrid polyaniline-gold nanostructures synthesized according to a preferred embodiment of the present invention display an excellent bistable electronic behavior, they are stable in a wide range of temperatures and they exhibit reproducible properties when submitted to repeated operation cycles. The bistability of the hybrid polyaniline-gold nanostructures synthesized according to a preferred embodiment of the present invention is characterized by a high ON/OFF ratio and by a low resistivity of the system in the ON state. These properties make the hybrid polyaniline-gold nanostructures synthesized according to a preferred embodiment of the present invention especially suitable for the application in non-volatile memory devices or field emission transistors.

The preferred embodiment of the present invention described with respect to the preparation of hybrid polyaniline-gold nanostructures is extremely versatile and it is possible to apply it with a large variety of polymers and of nanoparticles. The method of producing hybrid nanostructures of the present invention can be, in fact, applied not only for the preparation of hybrid polymer-metal nanostructures, but also to produce hybrid polymer-fullerenes nanostructures or hybrid polymer-metal compounds nanostructures. Moreover, several polymerizing methods can be employed for the synthesis of the polymeric structure in the presence of the dispersion of nanoparticles. Furthermore, by providing the nanoparticles with functionalizing groups, it is possible to precisely tailor the interaction between the nanoparticles and the polymeric structure in the hybrid nanostructures.

For these reasons, the method of producing hybrid polymer-metal nanostructures or hybrid polymer-metal compounds nanostructures of the present invention can be applied to synthesize materials suitable for a wide range of applications. The hybrid nanostructures synthesized according to the method of the present invention can be employed for instance for sensors, light-emitting diodes, photovoltaic cells, catalysts, drug delivery systems and data storage systems.

### REFERENCES

[1] R. J. Tseng et al., Nano Letters, 5 (2005) 1077
[2] Y. Wang et al., Langmuir, 21 (2005) 833
[3] J. X. Huang, R. B. Kaner, Angew. Chem. Int. Ed, 43 (2004) 5817
[4] N. Chiou, A. J. Epstein, Advanced Materials, 17 (2005) 1679
[5] X. Jing et al., Ultrasonics Sonochemistry, 14 (2007) 75
[6] M.J. Hostetler et al., Langmuir, 14 (1998) 17

## Claims

1. A method of producing hybrid polymer-metal nanostructures or hybrid polymer-metal compounds nanostructures, the method comprising the steps of,
providing a dispersion of metal nanoparticies or of metal compounds nanoparticles in an aqueous phase,
preparing an organic solution by mixing the monomers of a conducting polymer with a reagent such as CCl4, benzene, toluene, methylene, chloride, xylene, hexane, diethylether, dichloromethane, carbon disulfide, tetrahydrofuran, chloroform, methylene chloride, N-methyl-2-pyrrolidinone, a polar aprotic solvent, dimethyl acetamide, dimethyl formamide, ethyl acetate, an ester solvent, an ester alcohol,
adding said dispersion of metal nanoparticles or of metal compounds nanoparticles in said aqueous phase to said organic solution so as to form a biphasic system comprising an interface between said aqueous phase and said organic solution,
polymerizing said monomers of said conducting polymer in the presence of said dispersion,
wherein said step of polymerizing said monomers of said conducting polymer in the presence of said dispersion is performed by interfacial polymerization so that said conducting polymer forms nanofibers or nanoparticles.

2. The method of claim 1, wherein said step of providing metal nanoparticles in an aqueous phase further comprises the step of functionalizing said metal nanoparticles with an organic ligand.

3. The method of any one of the preceding claims, wherein said metal nanoparticles are made of at least one of gold, palladium, silver, platinum, copper, titanium, cobalt.

4. The method of any one of the preceding claims, wherein said metal nanoparticles have a mean particle size of 25 nm or less.

5. The method of any one of the preceding claims, wherein said metal nanoparticles have a size uniformity of 2 nm or less.

6. The method of one of claims 1 to 5, wherein said nanofibers have a mean diameter of 100 nm or less, or a length ranging from at least 50 nm to 100 µm, or a mean diameter of 100 nm or less and a length ranging from at least 50 nm to 100 µm.

7. The method of any one of the preceding claims, wherein said conducting polymer is polyaniline.

## Patentansprüche

1. Verfahren zur Herstellung von hybriden Polymer-Metall-Nanostrukturen oder hybriden Polymer-Metallverbindungs-Nanostrukturen, wobei das Verfahren die Schritte umfasst von:
Vorsehen einer Dispersion aus Metallnanopartikeln oder von Metallverbindungsnanopartikeln in einer wässrigen Phase,
Herstellen einer organischen Lösung durch Mischen der Monomere eines leitfähigen Polymers mit einem Reagenz wie beispielsweise CCI₄, Benzol, Toluol, Methylen, Chlorid, Xylol, Hexan, Diethylether, Dichlormethan, Schwefelkohlenstoff, Tetrahydrofuran, Chloroform, Methylenchlorid, N-Methyl-2-pyrrolidinon, einem polaren aprotischen Lösemittel, Dimethylacetamid, Dimethylformamid, Ethylacetat, einem Esterlösemittel, einem Esteralkohol,
Hinzufügen der Dispersion aus Metallnanopartikeln oder aus Metallverbindungsnanopartikel in der wässrigen Phase zu der organischen Lösung, sodass ein Zweiphasensystem gebildet wird, das eine Grenzfläche zwischen der wässrigen Phase und der organischen Lösung umfasst,
Polymerisieren der Monomere des leitfähigen Polymers in Gegenwart der Dispersion,
wobei der Schritt des Polymerisierens der Monomere des leitfähigen Polymers in Gegenwart der Dispersion durch Grenzflächenpolymerisation derart durchgeführt wird, dass das leitfähige Polymer Nanofasern oder Nanopartikel bildet.

2. Verfahren gemäß Anspruch 1, wobei der Schritt des Vorsehens von Metallnanopartikeln in einer wässrigen Phase ferner den Schritt der Funktionalisierung der Metallnanopartikel mit einem organischen Liganden umfasst.

3. Verfahren nach einem der vorhergehenden Ansprüche, wobei die Metallnanopartikel aus mindestens einem aus Gold, Palladium, Silber, Platin, Kupfer, Titan, Kobalt hergestellt sind.

4. Verfahren gemäß einem der vorhergehenden Ansprüche, wobei die Metallnanopartikel eine durchschnittliche Partikelgröße von 25 nm oder weniger aufweisen.

5. Verfahren gemäß einem der vorhergehenden Ansprüche, wobei die Metallnanopartikel eine Größeneinheitlichkeit von 2 nm oder weniger aufweisen.

6. Verfahren gemäß einem der Ansprüche 1 bis 5, wobei die Nanofasern einen durchschnittlichen Durchmesser von 100 nm oder weniger oder eine Länge aufweisen, die in einem Bereich von mindestens 50 nm bis 100 µm liegt, oder einen durchschnittlichen Durchmesser von 100 nm oder weniger und eine Länge aufweisen, die in einem Bereich von mindestens 50 nm bis 100 µm liegt.

7. Verfahren gemäß einem der vorhergehenden Ansprüche, wobei das leitfähige Polymer Polyanilin ist.

## Revendications

1. Procédé de production de nanostructures hybrides de polymère-métal ou de nanostructures de composés hybrides de polymère-métal, le procédé comprenant les étapes consistant à,
fournir une dispersion de nanoparticules métalliques ou de nanoparticules de composés métalliques dans une phase aqueuse, préparer une solution organique en mélangeant les monomères d'un polymère conducteur avec un réactif tel que le CC14, le benzène, le toluène, le méthylène, un chlorure, le xylène, l'hexane, le diéthyléther, le dichlorométhane, le disulfure de carbone, le tétrahydrofuranne, le chloroforme, le chlorure de méthylène, la N-méthyl-2-pyrrolidinone, un solvant aprotique polaire, l'acétamide de diméthyle, le formamide de diméthyle, l'acétate d'éthyle, un solvant de type ester, un alcool d'ester,
ajouter ladite dispersion de nanoparticules métalliques ou de nanoparticules de composés métalliques dans ladite phase aqueuse à ladite solution organique de manière à former un système biphasique comprenant une interface entre ladite phase aqueuse et ladite solution organique,
polymériser lesdits monomères dudit polymère conducteur en présence de ladite dispersion,
dans lequel ladite étape de polymérisation desdits monomères dudit polymère conducteur en présence de ladite dispersion est réalisée par polymérisation interfaciale de manière à ce que ledit polymère conducteur forme des nanofibres ou des nanoparticules.

2. Procédé selon la revendication 1, dans lequel ladite étape consistant à fournir des nanoparticules métalliques dans une phase aqueuse comprend en outre l'étape consistant à fonctionnaliser lesdites nanoparticules métalliques avec un ligand organique.

3. Procédé selon l'une quelconque des revendications précédentes, dans lequel lesdites nanoparticules métalliques sont faites d'au moins un parmi l'or, le palladium, l'argent, le platine, le cuivre, le titane, le cobalt.

4. Procédé selon l'une quelconque des revendications précédentes, dans lequel lesdites nanoparticules métalliques ont une granulométrie moyenne de 25 nm ou moins.

5. Procédé selon l'une quelconque des revendications précédentes, dans lequel lesdites nanoparticules métalliques ont une uniformité de taille de 2 nm ou moins.

6. Procédé selon l'une des revendications 1 à 5, dans lequel lesdites nanofibres ont un diamètre moyen de 100 nm ou moins, ou une longueur située dans la plage d'au moins 50 nm à 100 µm, ou un diamètre moyen de 100 nm ou moins et une longueur située dans la plage d'au moins 50 nm à 100 µm.

7. Procédé selon l'une quelconque des revendications précédentes, dans lequel ledit polymère conducteur est de la polyaniline.
